# EUROPEAN PATENT APPLICATION

(11) **EP 4 406 741 A1**
(43) Date of publication of application: **31.07.2024**
(21) Application number: 22884969.1
(22) Date of filing: 01.04.2022
(51) Int. Cl.: B41C 1/10, B41N 1/08, G03F 7/32

(54) **IMAGEABLE COMPOSITION FOR PHOTOSENSITIVE NEGATIVE LITHOGRAPHIC PRINTING PLATE, AND PLATEMAKING METHOD THEREFOR**

(30) Priority: 26.10.2021 CN 202111248590
(71) Applicant: Zhejiang Konita New Materials Co., Ltd., Wenzhou, Zhejiang 325013 (CN)
(72) Inventor: WENG, Yinqiao, Wenzhou, Zhejiang 325013 (CN); YING, Zuoting, Wenzhou, Zhejiang 325013 (CN); GAO, Miao, Wenzhou, Zhejiang 325013 (CN); XU, Nengping, Wenzhou, Zhejiang 325013 (CN); MA, Xianyao, Wenzhou, Zhejiang 325013 (CN); PAN, Feng, Wenzhou, Zhejiang 325013 (CN); CHANG, Shiwang, Wenzhou, Zhejiang 325013 (CN); JIN, Jianchen, Wenzhou, Zhejiang 325013 (CN); TAO, Ting, Fort Collins, Colorado 80525 (US)
(74) Representative: Patentanwälte und Rechtsanwalt Weiß, Arat & Partner mbB
(86) International application number: PCT/CN2022/084721
(87) International publication number: WO 2023/071053

(57) **Abstract**

Provided are an imageable composition for a photosensitive negative lithographic printing plate, and a platemaking method therefor. The imageable composition comprises the following components in parts by mass: 25-65 parts of a free radical polymerizable compound, 0.5-25 parts of a photoinitiator, 10-60 parts of a binder, and 1-20 parts of a development accelerator. The platemaking method comprises the following steps: (1) coating a substrate, which has a hydrophilic surface or a hydrophilic layer, with an imageable composition to obtain a photosensitive negative lithographic printing plate precursor; (2) exposing the lithographic printing plate precursor by using laser light and according to a required image, so as to form an exposed region and an unexposed region; and (3) removing the unexposed region from the exposed printing plate precursor by means of a development process, so as to obtain a required lithographic printing plate. By means of the imageable composition and the platemaking method, a flexible development procedure of "on-machine development" or "off-machine development" can be realized, and a prepared printing plate has an excellent printing performance.

## Description

### TECHNICAL FIELD

This invention belongs to the technical field of the lithographic printing plate preparation, and specifically relates to an imageable composition for photosensitive negative-working lithographic printing plate and a platemaking method therefor.

### BACKGROUND

The latest development in the field of lithographic printing plate benefits from the increasing popularity of digital technology, which uses computers to electronically process, store and output image information. Various new image output methods corresponding to such digital technology have been put into practice. From this, the Computer-to-Plate (CTP) Technology was born, in which digital image information can be loaded with highly convergent radiation such as a laser, and the laser is used to directly scan and expose the original edition for lithographic printing plate. Such technology has attracted much attention since it no longer relies on the advantages of producing lithographic printing plates by using traditional films, and has become one of the important technical issues in the field of lithographic printing plates.

In the production process of the traditional lithographic printing plate, it is necessary to remove the unnecessary photosensitive coating by dissolving with a developer after exposure, which relatively time-consuming and increases costs. Especially in recent years, as considered from environment protection, the disposal of waste liquid discharged with a strong alkaline solution in the development processing has become a subject of great concern to the entire industry. Therefore, in pursuit of further simplifying the platemaking process and reducing wastewater treatment, a variety of new technologies, including printing plate precursors that can be put on-press without chemical development after exposure or a production process that can be performed off-press development in a nearly neutral aqueous solution, have become a challenging issue in the field of technology research currently.

As one of the challenging platemaking techniques described above, a CTP printing plate precursor and its platemaking method called "on-press development" or "processless" have been proposed, and the unexposed portions of the image recording layer of this lithographic printing plate precursor can be removed by an ink and/or a dampening solution on the printing press through mechanical contact of the rotating drum, thereby obtaining a lithographic printing plate. The processless CTP plate has obvious advantages in energy saving and emission reduction. First of all, the processless CTP plate does not require the use of chemical reagents for special treatment, eliminating the high costs caused by developing procedure, and saving the cost of purchasing chemical reagents and related instruments and maintenance costs. Secondly, the processless CTP plate does not require the use of chemicals for plate development. Compared with traditional CTP plates, there is one less processing, which simplifies the production process, makes the operation easier, and saves production and preparation time.

Another solution to simplify the process and solve the problem of waste liquid is to use a nearly neutral aqueous solution for development, also known as a "low-chemistry treatment" platemaking process. Compared with the "processless" technique described above, the advantage of this method is that it can detect the quality of the image after exposure and before putting it on the printing press, and avoid contamination of the unexposed areas caused by the ambient light on the printing plate. EP 1342568 discloses a method of making a thermosensitive CTP lithographic printing plate such that a thermographic precursor comprising hydrophobic thermoplastic polymer particles which are coalesced upon heating can be developed with a gum. EP 1751625 provides a method of making a lithographic printing plate from a photopolymer CTP printing plate precursor. The exposure plate is a simplified process in which development and gumming occur simultaneously in a single bath with a gum. Since the unexposed areas on the photopolymer plate are removed by the gumming step, it can be stored in ambient light for a long period of time before the exposure plate is mounted on the printing press, and visible images can be provided before the plate is mounted on the printing press. In addition, it has a better cleaning effect to treat with a gum than to treat with fountain solution and ink on the printing press.

After decades of development in the field of CTP lithographic printing plates, two mainstream trends have been formed: thermosensitive and photosensitive. Thermosensitive technology uses near-infrared (wavelength 830nm) laser imaging, while photosensitive technology uses ultraviolet and visible light (wavelength 380nm to 405nm) laser imaging. Chinese patent document CN106313870B discloses a method for preparing a thermosensitive negative-working CTP lithographic printing plate. The patent document adopts the method of directly applying it to a printing press for development and imaging after exposure, or low-chemistry development and imaging after exposure and then putting it on the printing press to achieve off-press development. At the same time, it can also achieve on-press development in the platemaking method, satisfying customers to choose a more practical method according to actual situations.

At present, the market of chemistry-free thermosensitive CTP lithographic printing plates at domestic and abroad is expanding year by year, but chemistry-free photosensitive lithographic printing plates are still limited to the low-chemistry technology in the field of violet laser (Violet), the development of photosensitive processless lithographic printing plates in the field of ultraviolet light (UV) is still a blank. The on-press development or processless CTP lithographic printing plates in the photosensitive field have not yet been used in the market, and it is seriously behind the thermosensitive CTP lithographic printing plate technology in terms of implementation of environmental protection platemaking and the development of wastewater emission control. Therefore, the research and development of chemistry-free photosensitive CTP lithographic printing plates is an inevitable trend to adapt to green printing and energy-saving and environmental protection policies, and has very positive significance.

Compared with the thermosensitive negative-working processless CTP lithographic printing plate, the ultraviolet negative-working processless CTP lithographic printing plate requires less energy for exposure, and the design needs to improve photosensitivity of the imageable composition from hydrophilicity to lipophilicity. The present invention uses multifunctional urethane acrylate or multifunctional urethane methacrylate containing high crosslinking density. Free radical polymerizable compounds are prepared through condensation reactions of components such as diisocyanate, polyol, and hydroxyethyl (methyl) acrylate; a photoinitiator that can quickly produce free radical crosslinking under ultraviolet radiation and a high-tolerance development accelerator are selected to improve photosensitivity and imaging function; thereby achieving a breakthrough in the technology of ultraviolet negative-working processless CTP lithographic printing plate.

### SUMMARY OF THE INVENTION

Therefore, the technical problem to be solved by the present invention is to overcome that the large amount of corrosive developing solution produced in the platemaking process of photosensitive CTP lithographic printing plates, and at the same time to solve the shortage of a sole development process, thereby providing two flexible development processes that can be either "off-press development" or "on-press development", which achieve an imageable composition that meets the actual needs of customers and a photosensitive negative-working lithographic printing plate made from the imageable composition.

The present invention provides an imageable composition comprising the following components in parts by mass:
25 to 65 parts of a free radical polymerizable compound,
0.5 to 25 parts of a photoinitiator,
10 to 60 parts of a binder, and
1 to 20 parts of a development accelerator;
wherein the free radical polymerizable compound is a polymerizable monomer and/or oligomer containing at least one ethylenically unsaturated bond;
the photoinitiator has one or more absorption peaks or absorption shoulder bands in the UV-violet range;
the binder is a polymer with a main chain containing carbons;
the development accelerator is a low molecular weight hydrophilic organic compound or a high molecular weight hydrophilic polymer.

Preferably, the photoinitiator is sensitive to radiation in a wavelength ranging from 350nm to 450nm.

Preferably, the polymerizable monomer and/or oligomer is one or more of acrylate, methacrylate, urethane acrylate, urethane methacrylate, cyclic oxide acrylates or cyclic oxide methacrylates, polyol acrylates, polyol methacrylates, urethane acrylates, urethane methacrylates, polyether acrylates and polyether methacrylates.

Preferably, the photoinitiator is one or more of onium salt, trihalomethyl compound, carbonyl compound, azide compound, coumarin, ketocoumarin, anthraquinone, organoboron compound, oxime ester and phosphine oxide.

Preferably, the polymer with a main chain containing carbons is a polymer derived from at least one of acrylic acid, methacrylic acid, acrylate, methacrylate, acrylamide, methacrylamide, styrene and derivatives thereof, acrylonitrile, methacrylonitrile, N-substituted cyclic imides, and maleic anhydride constituting repeating units.

Preferably, the polymer with a main chain containing carbon has an average molecular weight ranging from 5,000 to 100,000.

Preferably, the low molecular weight hydrophilic organic compound used as the development accelerator is polyhydric alcohol and ether or ester derivatives thereof, organic amine and salts thereof, organic sulfonic acids and salts thereof; the high molecular weight hydrophilic polymers used as development accelerator is one or more of polyethylene glycol, gum arabic, starch, cellulose, dextrin, polysaccharides, and homopolymers or copolymers containing carboxyl, sulfonic acid, phosphonic acid, amide group, and vinyl pyrrolidone monomers.

The present invention also provides a platemaking method for a photosensitive negative-working lithographic printing plate, wherein the method comprises the following steps:
(1) coating on a substrate, which has a hydrophilic surface or a hydrophilic layer, with an imageable composition to obtain a photosensitive negative-working lithographic printing plate precursor;
(2) patternedly exposing the lithographic printing plate precursor to form an exposed region and an unexposed region;
(3) removing the unexposed region from the exposed printing plate precursor by means of a development process, so as to obtain a required lithographic printing plate, the development process is any one of (i) on-press development: using a dampening solution and/or lithography ink to perform development on a printing machine; and (ii) off-press development: using a developing solution to develop in a plate processor outside the printing machine.

The imageable coating in the platemaking method comprises the following components in parts by mass:
25 to 65 parts of a free radical polymerizable compound,
0.5 to 25 parts of a photoinitiator,
10 to 60 parts of a binder, and
1 to 20 parts of a development accelerator;
wherein the free radical polymerizable compound is a polymerizable monomer and/or oligomer containing at least one ethylenically unsaturated bond;
the photoinitiator has one or more absorption peaks or absorption shoulder bands in the UV-violet range;
the binder is a polymer with a main chain containing carbons;
the development accelerator is a low molecular weight hydrophilic organic compound or a high molecular weight hydrophilic polymer.

The developing solution for off-press development used in the platemaking method comprises a carbonate and/or a bicarbonate, and the carbonate and/or the bicarbonate in the developing solution has a mass fraction ranging from 1% to 20%, and the pH value of the developing solution is in a range from 6 to 11.

Preferably, the carbonate in the developing solution is an alkali metal carbonate; and the bicarbonate in the developing solution is an alkali metal bicarbonate.

Further, the alkali metal carbonate is at least one of sodium carbonate, potassium carbonate or lithium carbonate.

The alkali metal bicarbonate is at least one of sodium bicarbonate, potassium bicarbonate or lithium bicarbonate.

Further, the developing solution further comprises at least one of surfactant and/or water-soluble polymer compound.

The mass concentration of the surfactant in the developing solution is ranging from 0.1% to 10%.

The mass concentration of the water-soluble polymer compound in the developing solution is ranging from 0.1% to 20%.

Preferably, the pH value of the developing solution is ranging from 7 to 10.

The substrate with a hydrophilic surface or endowed with a hydrophilic layer is preferably an aluminum substrate that has been electrolytically roughened and anodized.

In the step (3), before the development step, a step of preheating the exposed printing plate precursor is can also be included.

Further, the imageable coating may comprise one or more layers.

The present invention also provides a photosensitive negative-working lithographic printing plate prepared by the above-mentioned platemaking method.

Compared with the prior art, the technical solution of the present invention has the following advantages:
1) For the imageable composition provided by the present invention and the photosensitive negative-working lithographic printing plate prepared by using the composition, by adjusting the type and content of each component in the imageable composition, using (methyl) acrylate ester with high crosslinking density and multifunctional amino acid esterification, selecting a photoinitiator that can quickly produce free radical crosslinking under ultraviolet radiation, and a high tolerance development promoter to improve exposure light speed and imaging function, it has achieved a CTP lithographic platemaking process in the photosensitive field, The plate making process is more environmentally friendly and safe, which can effectively adapting to various development processes, and ensuring that customers can flexibly choose development processes according to their actual needs, such as "off-press development" and "on-press development". Moreover, choosing different development processes will not harm the final development effect.
2) In the platemaking method for a photosensitive negative-working lithographic printing plate provided by the present invention, the developing solution selected during the off-press development process mainly comprises carbonate and bicarbonate, and does not comprise highly corrosive alkaline substances, reducing the discharge of waste liquid. In addition, carbonate ions and bicarbonate ions can act as buffer agents to prevent pH fluctuation even when the developing solution has been used for a long period of time. Therefore, deterioration of developing performance and generation of development scum due to pH fluctuation can be prevented.

### DETAILED DESCRIPTION

In order to better illustrate the purpose, technical solution and advantages of the present invention, the present invention is further described in detail with reference to specific embodiments. Apparently, the present invention may be carried out in many different forms and should not be construed as being limited to the embodiments set forth herein. Actually, the embodiments are provided so that this disclosure will be thorough and complete, and will fully convey the idea of the invention to those skilled in the art, the present invention will be limited only by claims.

The term "off-press development" in the context of the present invention refers to a step of removing an image-recording layer of a lithographic printing plate precursor by contacting with a liquid (usually a developing solution) in a device (typically an automatic plate processor), thereby exposing the surface of a hydrophilic substrate. The term "on-press development" refers to a step of removing an image-recording layer of a lithographic printing plate precursor by contacting with the ink and/or dampening solution on a printing press, thereby exposing the surface of a hydrophilic substrate. The term "processless" refers to a platemaking method, which does not require any mechanical or chemical treatment after exposure and prior to the printing press, unless otherwise specified.

The platemaking method of the lithographic printing plate of the present invention will be described in detail hereinafter. In addition, the other steps will be described after the most characteristic step, that is, the development process is illustrated.

### Developing process:

The platemaking method of the lithographic printing plate of the present invention comprises the following steps: removing an unexposed area of an exposed printing plate precursor through a developing process with or without a preheating step. The developing process is any one of the following: (i) on-press development, which is performed on a printing press using a dampening solution and/or a lithographic ink; (ii) off-press development, which is performed in a plate processor outside a printing press using a developing solution comprising carbonate and/or bicarbonate.

### a. On-press development:

The printing plate precursor of the present invention is suitable for "on-press development". For example, mounting the printing plate precursor directly onto the printing press, rotating the plate cylinder while feeding the dampening solution and/or ink to the imageable coating layer of the printing plate precursor. A non-exposure area of the imageable coating layer is removed from the carrier after the plate cylinder has been rotated for a number of revolutions, preferably less than 50 revolutions, wherein the non-exposure area of the imageable coating layer may be removed in any order during printing by a suitable dampening solution, lithographic ink, or a combination of both.

In order to better illustrate the purpose, technical solutions and advantages of the present invention, the present invention will be further described below in conjunction with specific embodiments. The present invention may be embodied in many different forms and should not be construed as limited to the embodiments set forth herein. Rather, these embodiments are provided so that this disclosure will be thorough and complete and will fully convey the concept of the invention to those skilled in the art, and the present invention will only be defined by the claims.

The term "off-press development" in the present invention refers to the step of removing the image-recording layer of a lithographic printing plate precursor by contact with a liquid (usually a developing solution) in a device (usually an automatic plate processor), The surface of the hydrophilic substrate is thus exposed; the term "on-press development" refers to the step of removing the image-recording layer of a lithographic printing plate precursor by contact with ink and/or fountain solution on-press, thereby exposing The surface of a hydrophilic substrate; the term "processless" refers to a platemaking method that does not require any mechanical or chemical treatment after exposure and prior to printing, unless otherwise specified.

Hereinafter, the platemaking method for a photosensitive negative-working lithographic printing plate of the present invention will be described in detail. In addition, other steps will be described after the development step which is the most characteristic step has been described.

In a preferred embodiment, only the dampening solution is fed to the printing plate at the start of the printing press, and then an ink is fed after a few revolutions of the device.

In another alternative embodiment, the dampening solution and ink can be fed at the same time as the printing press is started, or only ink is fed to the printing plate at the beginning, and then dampening solution is fed after the device has been turned a few turns.

In yet another alternative embodiment, a single-fluid ink can be fed to the printing plate for on-press processing. The single-fluid ink comprises an ink phase (also known as a hydrophobic or oleophilic phase) and a polar phase, wherein the polar phase replaces an aqueous dampening solution used in conventional offset printing. Suitable single-fluid inks have been disclosed, for example, in U.S. Patent 4045232, U.S. Patent 4981517 and U.S. Patent 6140392. In a most preferred embodiment, the single fluid ink comprises an ink phase and a polyol phase, as described in WO 00/32705.

This kind of developing process avoids the use of conventional alkaline developing solution and independent developing equipment.

### Off-press development:

There is no particular limit for the off-press development processing of the present invention, and the off-press development processing can be carried out any known method. Development can be a so-called "manual" development or "dip" development, or can be accomplished by rinsing with an automatic development device (typically a rinse machine). In the case of "manual" development, the entire imaging element is sanded with a sponge or a cotton pad fully impregnated with a suitable developing solution (as described below), followed by rinsing with water for development. "Dip" development involves immersing the imaging element in a stirred tank or tray containing a suitable developing solution, and staying for 10-60 seconds (especially 20-40 seconds), followed by rinsing with water, with or without a sponge or a cotton pad sanding. The use of automatic developing equipment is well known and generally involves pumping the developing solution into a developing tank and then ejecting it from a spray nozzle. The imaging element is brought into contact with the developing solution in a suitable manner. The automatic developing equipment may also comprise a suitable sanding mechanism (such as a brush or a roller) and a suitable number of conveying rollers. Some developing devices comprise a laser exposure device, and comprise an imaging section and a developing section. For example, the rinsing solution (or developing solution) can be applied to the imaging element in the following manner: sanding, spraying, ejecting, dipping, immersing, slitting, and narrow slit mold coating (see, for example, U.S. Patent 6478483, Maruyama et al. Figures 1 and 2) or reverse roll coating (as described in Figure 4 of U.S. Patent 5887214, Kurui et al.), or wiping the outer layer with a rinsing solution or allowing it to contact with a glue-containing roller, a dipping pad or an applicator. A rinsing solution, for example, can be used to brush the imaging element or poured onto an imaging surface, or a spray nozzle system, for example, described in EP 1788431 and U.S. Patent 6992688 (Shimazu et al.) is used to develop the image by spraying the surface with a force sufficient to remove the unexposed area. Similarly, the imaging element can be immersed in a rinsing solution and sanded by hand or with a device.

Suitable off-press development devices have at least one roller for sanding or brushing the imaging element while applying the developing solution. The unexposed areas of the imaged layer can be more completely and quickly removed from printing plate by using such a rinsing device. Residual developing solution can be removed (for example, using a squeegee or a roller) or left on the resulting printing plate without any rinsing steps. Excess developing solution can be collected in a tank and used several times and replenished from a reservoir if necessary. Developing supplements may have the same concentration as the developing solution used in the rinsing, or be provided in a concentrated form and diluted with water at a suitable time. Fresh liquid may be used throughout the development process, but it is preferable to circulate the developed solution through a filter so that it can be reused. Any filter used to filter the developing solution applied in the development process may be used as long as it is capable of filtering foreign matter mixed in the developing solution. As for the materials of the filter, it is preferable to use a polyester resin, a polypropylene resin, a polyethylene resin, a cellulose resin, cotton, etc.. The mesh pore diameter of the filter is preferably 5-500µm, more preferably 10-200µm, and further preferably 20-100µm.

The off-press development step of the present invention is preferably carried out with an automatic processor quipped with a friction element, such as the automatic processor described in U.S. Patent 5148746 and 5568768 and the British Patent 2297719, particularly preferably an automatic processor with a rotating brush roller as a friction element. The lithographic printing plate precursor of the exposed image is subjected to a friction treatment while being transmitted. For the rotating brush roller, a known rotating brush roller manufactured by inserting a brush material into a plastic or metal roller can be used. As for the materials of the brush, a plastic fiber (for example, a polyester base such as polyethylene terephthalate or polybutylene terephthalate, a polyamide base such as nylon 6.6 or nylon 6.10, a polyacrylic acid base such as, polyacrylonitrile or polyalkyl (meth) acrylate and a polyolefin base, for example, polypropylene or polystyrene) may be used. For example, it is preferably that a brush material having a fiber diameter of 20 to 400 µm and a length of 5 to 30 mm can be used. The outer diameter of the rotating brush roller is preferably from 30 mm to 200 mm, and the peripheral speed of the brush on the friction plate is preferably from 0.1 to 5 m/sec.

The rotation direction of the rotating brush roller may be the same or the opposite direction with respect to the delivery direction of the lithographic printing plate precursor. However, when two or more rotating brush rollers are used, with respect to the delivery direction, it is preferred that at least one rotating brush roller rotates in the same direction, and at least one of the rotating brush rollers rotates in the opposite direction. With such a configuration, the non-image area of the photosensitive layer is removed more stably.

A conventional three-bath developing system can be used in the platemaking method of the lithographic printing plate of the present invention.

The three-bath developing system is a method to sequentially perform three treatment steps: an off-press development process, a washing process, and a gumming process, and the treatment liquids in each bath is used to perform respective treatment process, that is, the developing system has at least three treatment baths. In the platemaking method of the lithographic printing plate of the present invention, the washing step and the gumming process step may not be performed before and after the above-described off-press developing step, and only the developing process using the above developing solution may be used as a processing step, that is, only a single treatment bath is required (also known as single bath treatment).

The resulting lithographic printing plate after rinsing of off-press development can be placed onto a cylinder of the printing press, followed by applying an ink and a dampening solution to the printed side of the imaged and developed element.

It is noted that in the present invention, a drying step may be provided after the development step. In particular, it is preferably provided at the last step of the automatic processor.

### Developing solution:

The developing solution used in the platemaking method of the lithographic printing plate of the present invention is a neutral or weakly basic aqueous solution or aqueous dispersion comprising at least carbonate, bicarbonate or a combination thereof. Carbonate ion and bicarbonate ion can act as a buffer agent to prevent pH fluctuation even when the developing solution has been used for a long period of time. Therefore, it can prevent the deterioration of developing performance and the generation of development scum due to pH fluctuation. In order to allow carbonate ion and bicarbonate ion to be simultaneously present in the developing solution, the present invention preferably uses a combination of carbonate and bicarbonate, or may produce carbonate ions and bicarbonate ions by adding carbonate to a developing solution and followed by adjusting the pH. The carbonate or bicarbonate to be used are not particularly limited, and are preferably alkali metal salts thereof. Examples of alkali salts are lithium carbonate, lithium bicarbonate, sodium carbonate, sodium bicarbonate, potassium carbonate and potassium bicarbonate, wherein sodium carbonate, sodium bicarbonate, potassium carbonate and potassium bicarbonate are preferred, and sodium carbonate and sodium bicarbonate are particularly preferred. Alkali metal salts may be used alone or in combination of two or more of them.

The total amount of the carbonate salt and the bicarbonate salt is preferably from 1 to 20% by weight, more preferably from 3 to 15% by weight, based on the weight of the developing aqueous solution.

The developing solution of the present invention may further comprise a surfactant (for example, an anionic, nonionic, cationic or amphoteric surfactant).

Examples of the anionic surfactant comprises a aliphate, a rosin ester, a hydroxyalkane sulfonate, an alkane sulfonate, a dialkyl sulfosuccinate, a linear alkyl benzene sulfonate, a branched alkyl benzene sulfonate, an alkyl naphthalene sulfonate, an alkyl phenoxyl polyoxyethylene propyl sulfonate, a salt of polyoxyethylene alkyl sulfoyl phenyl ether, a N-methyl-N-oleyl sodium taurocholate, a monoamide N-alkyl sulfosuccinate disodium, a petroleum sulfonate, a sulfated castor oil, a sulfated tallow, a sulfate ester of aliphatic alkyl ester, a salt of alkyl sulfate, a sulfate of polyoxyethylene alkyl ether, a sulfate ester of aliphatic monoglyceride, a sulfate ester of polyoxyethylene alkyl phenyl ether, a sulfate esters of polyoxyethylene styrylphenyl ether, a salt of alkyl phospholipid, a phosphate salt of polyoxyethylene alkyl ether, a phosphate salt of polyoxyethylene alkyl phenyl ether, a partially saponified compound of styrene-maleic anhydride copolymer, a partially saponified compound of olefin-maleic anhydride copolymer or a naphthalene sulfonate formalin condensate. Among these anionic surfactants, a dialkyl sulfosuccinate and an alkyl naphthalene sulfonate are particularly preferred.

Examples of a suitable anionic surfactant include a sodium salt of alkylated naphthalene sulfonates, a disodium methylene-dinaphthyl-disulfonate, a sodium alkyl benzene sulfonate, a sodium alkylphenoxybenzene disulfonate, a sulfonated alkyl diphenyl ether, an ammonium nonadecafluoronanesulphonate or a potassium-sodium dioctyl-sulfosuccinate.

Suitable examples of nonionic surfactants include a polyoxyethylene alkyl ether, a polyoxyethylene alkyl aryl ether, wherein the aryl may be phenyl, naphthyl or aromatic heterocyclic compound, polyoxyethylene polystyrene phenyl ether, polyoxyethylene polyoxypropylene alkyl ether, polyoxyethylene polyoxypropylene block polymer, partial ester of glycerol aliphatic acid, partial ester of sorbitan aliphatic acid, partial ester of pentaerythritol aliphatic acid, propylene glycol monoaliphatic ester, partial ester of sucrose aliphatic acid, partial ester of polyoxyethylene sorbitan esteraliphatic acid, partial ester of polyoxyethylene sorbitol aliphatic acid, polyethylene glycol aliphatic ester, partial ester of polyglycerol aliphatic acid, polyoxyethylenated castor oil, partial ester of polyoxyethylene glycerol aliphatic acid, aliphatic diethanolamide, N,N-bis-2-hydroxyalkylamine, polyoxyethylene alkyl amine, triethanolamine aliphatic ester or trialkyl amine oxide. Among these nonionic surfactants, a polyoxyethylene alkyl phenyl ether, a polyoxyethylene alkyl naphthyl ether, and a polyoxyethylene-polyoxypropylene block polymer are particularly preferred.

Specific examples of a suitable nonionic surfactant includes an ethylene oxide adduct of sorbitol and/or sorbitan fatty acid ester, a polypropylene glycol glycidyl adduct, a dimethylsiloxane-ethylene oxide block copolymer, a dimethylsiloxane-(propylene oxide-ethylene oxide) block copolymer, and a polyol fatty acid ester.

Cationic surfactant is not particularly limited, and conventional known cationic surfactants for example, a alkylamine salt, a quaternary ammonium salt, a polyoxyethylene alkylamine salt, and a polyethylene polyamine derivative can be used.

Amphoteric surfactants available for the present invention are not particularly limited, and conventional known amphoteric surfactants, for example, an amino acid, a betaine or an amine oxide can be used.

In addition, an ethylene oxide adduct of alkynediols or alkynols, or a surfactant of fluorine group or a silicon group can also be used.

Two or more of the above surfactants may be used in combination. For example, a combination of two or more different anionic surfactants or a combination of an anionic surfactant and a nonionic surfactant may be preferred. The amount of such a surfactant is not particularly limited, but is preferably from 0.1 to 10% by weight, and more preferably from 0.1 to 5% by weight.

The developing solution of the present invention may further comprise a water-soluble polymer, such as a soybean polysaccharide, a modified starch, an arabic gum, a dextrin, a cellulose derivative (for example, a carboxymethyl cellulose, a carboxyethyl cellulose or a methylcellulose ) and a modified product thereof, an amylopectin, a polyvinyl alcohol and a derivative thereof, a polyvinylpyrrolidone, a polyacrylamide, an acrylamide copolymer, a methyl vinyl ether/maleic anhydride copolymer, a vinyl acetate/maleic anhydride copolymer or a styrene/maleic anhydride copolymer, etc..

Among the water-soluble polymers, a soybean polysaccharide, a modified starche, an arabic gum, a dextrin, a carboxymethyl cellulose, a polyvinyl alcohol, etc. are particularly preferable.

Two or more of water-soluble polymers can be used in combination. The content of water-soluble polymers in the developing solution is preferably from 0.1 to 20% by weight, and more preferably from 0.5 to 10% by weight.

In addition to the above components, the developing solution of the present invention may further comprise an antifoaming agent, an organic acid, an inorganic acid, an inorganic salt, etc..

As for the antifoaming agent, a conventional polysiloxane-based self-emulsify or emulsified antifoaming agent is preferably used, and a silicone antifoaming agent is preferably. Any one of an emulsified dispersing antifoaming agent, a dissolving antifoaming agent, etc. can be used. The content of the antifoaming agent is preferably from 0.001 to 1.0% by weight.

Examples of the organic acid include ethylenediamine tetraacetic acid, citric acid, acetic acid, oxalic acid, malonic acid, salicylic acid, octanoic acid, tartaric acid, malic acid, lactic acid, levulinic acid, p-toluenesulfonic acid, xylenesulfonic acid, phytic acid or an organic phosphonic acid, etc. The organic acid can also be used in the form of an alkali salt or an ammonium salt, such as an ethylenediamine tetraacetic acid disodium salt. The content of the organic acid is preferably 0.1 to 5 % by weight.

Examples of the inorganic acid or inorganic salt include phosphoric acid, metaphosphoric acid, ammonium dihydrogen phosphate, diammonium phosphate, sodium dihydrogen phosphate, disodium hydrogen phosphate, monopotassium phosphate, dipotassium phosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogen sulfate, nickel sulfate, etc.. The content of the inorganic salt is preferably from 0.1 to 5% by weight.

The pH of the developing solution in the present invention is not particularly limited as long as it is a pH exhibiting a buffering effect, and is preferably in the range of 6 to 11, and is particularly preferably in the range of 7 to 10.

### Printing plate precursors:

The lithographic printing plate precursor used in the present invention is characterized by having a negative-working image forming ability. That is, light-exposed areas are cured to form image portions, and the unexposed portions are removed by development processing as described above, thus to form non-image portions.

### Substrate:

The substrate used in the lithographic printing plate precursor of the present invention is not particularly limited, as long as the substrate has a hydrophilic surface, or at least has a surface that is more hydrophilic than the imageable layer. The substrate can be composed of any material commonly used in the preparation of imageable elements such as lithographic printing plates, which is usually in the form of sheets, films or foils (or meshes) and has a certain strength stability and ductility, and is resistant to dimensional changes under the conditions of use to ensure that the color is correct during printing. Typically the substrate can be any self-supporting materials, including a polymeric film (eg, a polyester, a polyethylene, a polycarbonate, a cellulose ester polymer, and a polystyrene film), a glass, a ceramic, a metal sheet or foil or a rigid paper (a paper comprising resin or metal coating) or any laminates of these materials (for example a laminate of aluminum foil laminated to a polyester film). Metal supports include a sheet or foil of aluminum, copper, zinc, titanium, and an alloy thereof.

A particularly preferred substrate of the present invention is composed of an aluminum support known in the art, and is produced by grinding and roughing a physical (mechanical) grinding plate, an electrochemical graining plate or a chemical graining plate, followed by treating with acid anodic oxidation. A useful hydrophilic lithography substrate is an aluminum support ground electrochemically and anodized with sulfuric or phosphoric acid.

Sulfuric acid anodization of an aluminum support typically produces 1.5-5g/m², more typically 2.5-4g/m² of oxides (coverage) on the aluminum surface. Phosphoric acid anodizing of aluminum supports typically produces 1-5g/m², more typically 1.5-3g/m² of oxides on the aluminum surface. Higher oxides weight (at least 3g/m²) provides longer print life when anodized with sulfuric acid.

The anodized aluminum supports may also be treated with materials such as silicates, dextrins, calcium fluozirconates, hexafluorosilicic acids, polyvinylphosphonic acids (PVPA), vinylphosphonic acid copolymers, methacrylic acids or acrylic copolymers to increase hydrophilicity.

The thickness of the substrate can vary but it should be strong enough to withstand the wear of the printing and flexible enough to wind. A commonly used thickness is 0.1 mm to 0.7 mm for a treated aluminum foil.

Furthermore, the substrate may also be a cylindrical surface having an imageable layer thereon, such as a component of a printing press. The use of such an imaging cylinder has been described in U.S. Patent 5713287 (Gelbart).

### Imageable coating layer:

The imageable coating layer of the present invention comprises at least a radically polymerizable compound, a photoinitiator, an initiator, a binder and a development accelerator. Furthermore, in the present invention, "Substrate coated with an imageable composition" means a radiation-sensitive composition coating can be provided by direct contact with a substrate, and other layers can also be provided between the substrate and the radiation-sensitive coating or above the radiation-sensitive coating. The presence of any layers, such as a protective layer, a substrate layer, an intermediate layer, a back coating layer, etc. as desired in the lithographic printing plate precursor is possible.

### Radically polymerizable compound

Radically polymerizable compounds are well known to those skilled in the art and have been described in considerable documents, for example: "Photoreactive Polymers: The Science ana Technology of Resists", A. Reiser, Wiley, New York, 1989, pages 102-177, BBMronoe; "Radiation Curing: Science and Technology", S.P. Pappas, Ed., Plenum, New York, 1992, pages 399-440; "Polymer Imaging", A.B. Cohen and P. Walker; "Imaging Processes ana Material", I.M. Sturge et al., Van Nostrand Reinhold, New York, 1989, pages 226-262. Additionally, useful radically polymerizable components have also been described in European Patent 1182033 (Fujimaki et al.).

According to the present invention, the radically polymerizable compound is a polymeric monomer and/or oligomer containing at least one ethylenically unsaturated bond, and may preferably be selected from the group consisting of an acrylate of polyol, a methacrylate of polyol, a polyester acrylate, an urethane methacrylate, an epoxide acrylate, epoxide methacrylate, a polyester acrylate, a polyester methacrylate, a polyether acrylate, a polyether methacrylate.

Suitable free radical polymerizable monomers may include, for example, a poly-functionality acrylate monomer or a poly-functionality methyl acrylate monomer (eg, ethylene glycol, trimethylolpropane, pentaerythritol, ethylene glycol-ethoxylated, acrylate of trimethylolpropane-ethoxylated, methacrylate of trimethylolpropane-ethoxylated, a poly-functionality acrylate-carbamated, a poly-functionality methacrylate-carbamated, acrylate-epoxidized and methacrylate-epoxidized) and an oligoamine diacrylate. In addition to the acrylate groups and methacrylate groups, acrylic monomers or methacrylic monomers may also have other double bonds or epoxide groups. The acrylic monomer or methacrylic monomer may also comprise an acid (e.g. carboxylic acid) or basic (e.g. amine) functionalities. A useful free radical polymerizable compound comprises poly-functionality acrylate-carbamated, polyurethane acrylates, pentaerythritol tetracrylate, and other polymerizable monomers that are obvious to those skilled in the art.

The polymerizable compound is present in the composition in an amount sufficient to render the IR radiation-sensitive composition insoluble in the aqueous developing solution after exposure to radiation. The amount is generally from 25 to 65% by weight, typically from 30 to 60% by weight, based on the dry weight of the radiation-sensitive composition.

### Photoinitiator:

The free radical photoinitiators used in the present invention exhibit one or more absorption bands in the UV-violet range, and at least one of these bands extends to the visible range of the electromagnetic spectrum shown, or has a shoulder or one or more other secondary bands within the visible range. For example, one or more of onium salt, trihalomethyl compound, carbonyl compound, azide compound, coumarin, ketocoumarin, anthraquinone, organoboron compound, oxime ester and phosphine oxide.

Suitable onium salts comprise sulfonium salts, oxysulfoxide onium salts, oxonium salts, sulfoxide onium salts, phosphonium salts, diazonium salts, halonium salts such as iodonium salts. Specific examples comprise diphenyliodonium chloride, diphenyliodonium hexafluorophosphate, (4-methylphenyl)[4-(2-methylpropyl)-phenyl] iodonium, bis (4-tert-butylphenyl) iodonium hexafluorophosphate, diphenyliodonium hexafluoroantimonate, diphenyliodonium octylsulfate, diphenyliodonium octylthiosulfate, diphenyliodonium 2-carboxylate, p-toluenesulfonic acid N-methoxy-a-methylpyridylium, 4-methoxy-phenyl-diazonium tetrafluoroborate, 2-cyanoethyl-triphenylphosphonium chloride, bishexafluoroantimonate bis-[4-diphenyl sulfonium phenyl] thioether, bis-4-dodecyl phenyl iodide hexafluoroantimonate, triphenyl sulfonium hexafluoroantimonate, triphenyl sulfonium tetrafluoroborate, triphenyl sulfonium octylsulfate, phenoxybenzene hexafluoroantimonate phenyl diazo salt and hexafluoroantimonate phenylaminophenyl diazonium salt.

Photoinitiators also comprise trichloromethyltriazine-type initiation systems, as described in U.S. Patent 4,997,745; diaryliodonium salts and photosensitizers, as described in U.S. Patent 5,546,258; Spectral sensitizers and trichloromethyl triazines for visible light activation, as described in U.S. Patent No. 5,599,650; 3-ketocoumarins and polycarboxylic acid co-initiators for UV and visible light activation, such as anilino-N,N-diacetic acid and second coinitiators, as described in U.S. Patent No. 5,942,372; cyanine dyes, diaryliodonium salts, and carboxylic acid groups having a methylene group attached to an N, O, or S group directly attached to an aromatic ring, as described in US Patent No. 5,368,990. Suitable free radical initiators comprise, for example, 2-(4-methoxyphenyl)-4,6-di(trichloromethyl)-2-triazine, 2-(4-methoxy-1-naphthyl)-4,6-di(trichloromethyl)-1,3,5-triazine, anilino-N,N-diacetic acid, 2,2-dimethoxy-2-phenylethylphthalobenzene, 2-methyl-1-[4-(methylthio)phenyl-2-morpholinopropan -1-one, phenyl bis(2,4,6-trimethylbenzoyl)phosphine oxide, 3-benzoyl-7-methoxycoumarin, ketone coumarin 93, benzylethanolone or alkyl substituted anthraquinone, tert-butylammonium butyl borate triphenyl and triphenyl (n-butyl ) Tetraethylammonium borate.

An initiator composition comprising one or more initiator compounds is present in the radiation-sensitive composition in an amount of from 0.5 to 25%, preferably at least 1% to 20%, based on the total solid of a radiation-sensitive composition or the dry weight of an imageable coating layer.

### Binder:

The binder of the present invention is a polymer that has carbon in its main chain, and any one or more of binder polymers known in the art for use in a photosensitive layer of a negative-working lithographic printing plate precursor, etc. may be used without limitation.

A useful polymeric binder may be homogeneous, i.e., dissolved in a coating solvent, or may be present as discrete particles and include, but is not limited to, acrylic acid, methacrylic acid, a polymer derived from acrylate, a polymer derived from methacrylate, a polyvinyl acetal, a phenolic resin, a polymer derived from styrene and its derivative, an acrylonitrile, a methacrylonitrile, a N-substituted cyclic imide or a maleic anhydride, for example, binders as described in European Patent 1182033 (has been indicated in the above contents) and U.S. Patent 6309792 (has been indicated in the above contents), U.S. Patent 6569603 (has been indicated in the above contents), and U.S. Patent 6893797 (Munnelly et al.). Also useful binders are the vinyl carbazole polymer described in U.S. Patent 7175949 (Tao et al.).

On the other hand, a useful polymeric binder can also be particulate polymers that are distributed (usually uniformly) throughout the imageable layer, having an average particle size of from 10 to 10000 nm (typically from 20 to 800 nm). Typically the polymeric binders are solids at room temperature and are typically non-elastic thermoplastic. The polymeric binders comprise both hydrophilic and hydrophobic regions, which have been believed to be important for increasing the difference between exposed and unexposed regions by promoting development capabilities, and the presence of discrete particles tends to promote unexposed regions. Specific examples of polymeric binders of such embodiments have been described in U.S. Patent 6899994 (has been indicated in the above contents), WO 2009/030279 (Andriessen et al.), U.S. Patent 7261998 (Hayashi et al.), U.S. Patent 7659046 (Munnelly et al.) and European Patent 1614540 (Vermeersch et al).

In addition to the polymeric binders of the above embodiments, the imageable layer can optionally comprise one or more co-binders. A typical co-binder includes, for example, a cellulose derivative, polyvinyl alcohol, polyacrylic acid, polymethacrylic acid, polyvinylpyrrolidone, polylactide, polyvinylphosphonic acid, a synthetic copolymer such as a copolymer of alkoxy polyethylene glycol acrylate, a copolymer of alkoxy polyethylene glycol methacrylate.

The polymer used as a binder preferably has a typical average molecular weight of from 2,000 to 500,000, preferably from 5,000 to 100,000. The total amount of all binder polymers is usually from 10 to 60% by weight, preferably from 20 to 60% by weight, relative to the total weight of the non-volatile components of the composition.

### Development accelerator:

In order to effectively achieve "off-press development" and "on-press development" of the imageable coating layer simultaneously, the imageable composition of the present invention comprises are low molecular weight hydrophilic organic compounds or high molecular weight hydrophilic polymers. The low molecular weight hydrophilic organic compound used as the development accelerator is one or more of polyhydric alcohol and ether or ester derivatives thereof, organic amine and salts thereof, organic sulfonic acids and salts thereof. Examples comprise ethylene glycol, diethylene glycol, triethylene glycol, propylene glycol, dipropylene glycol and triepropylene glycol, glycerol, pentaerythritol and tri (2-hydroxyethyl) isocyanurate, triethanolamine, diethanolamine and monoethanolamine, toluenesulfonic acid, sodium dodecyl benzene sulfonate, sodium dibutylnaphthalene sulfonate, sodium dioctylsuccinate sulfonate, Calfax@10L-45, Emulsifier OS, DOWFAX@3B2 and NAXAN@ABL.

The high molecular weight hydrophilic polymers used as development accelerator is polyethylene glycol, gum arabic, starch, cellulose, dextrin, polysaccharides, and homopolymers or copolymers containing carboxyl, sulfonic acid, phosphonic acid, amide group, and vinyl pyrrolidone monomers.

The development accelerator is added in an amount of from 1 to 20% by weight, preferably from 1 to 15% by weight, relative to the total solid component weight of the imageable coating layer.

In addition, the composition of the present invention may also comprises, in regular quantities, various additives, such as a surfactant, a color dye, a contrast dye, a polymerization inhibitor, an antioxidant, or any combination thereof, or any other additives that are commonly used in lithographic techniques.

### Formation of the printing plate precursor:

A printing plate precursor having an imageable coating layer can be formed in the present invention by suitably applying the above imageable coating layer to the above-described substrate. Specifically, the imageable coating layer is dispersed or dissolved in a suitable coating solvent to form a mixed solution, and suitable equipment and processes such as spin coating, knife coating, gravure coating, mold coating, slot coating, bar coating, wire coating, roll coating or extruder hopper coating are used to apply the mixed solution to the surface of the substrate carrier, or to apply said composition by spraying it onto a suitable support such as a printing cylinder of a printing press. The coating solvent is then removed by drying in an oven at 70 °C to 160 °C to obtain said lithographic printing plate precursor.

The selection of solvent to be used herein depends on the properties of polymeric binders and other non-polymeric components in the composition. Typically coating solvents used under well known conditions and techniques in the art include, for example, acetone, cyclohexanone, methyl alcohol, ethyl alcohol, propyl alcohol, butanol, methyl ethyl ketone, methyl isobutyl ketone, tetrahydrofuran, 1-methoxy-2-propanol, 2-ethoxyl-ethanol, 2-methoxyethyl acetate, 1-methoxy-2-propyl acetate, dimethoxyethane, methyl lactate, ethyl lactate, N,N-dimethyl formamide, N,N-dimethylacetamide, tetramethylurea, N-methylpyrrolidone, dimethyl sulfoxide, γ-butyrolactone, etc., but is not limited to these solvents. The above solvents may be used alone or in combination of two or more thereof.

The coating weight of the imageable layer after drying is generally at least from 0.1 to 5g/m², preferably from 0.5 to 3g/m².

### Exposure:

In the lithographic printing plate precursor of the present invention, it is also preferred to provide a protective layer comprising one or more surface protective compounds on the imageable coating layer in order to prevent contamination of fat, oil, dust or oxidation and damage caused by scratching. As a material that can be used in the protective layer, either a water-soluble polymer or a water-insoluble polymer can be appropriately selected to be used, or two or more of them can be used in combination as required. Specific examples thereof include an arabic gum, an amylopectin, a cellulose derivative such as a carboxymethyl cellulose, a carboxyethyl cellulose or a methylcellulose, a dextrin, a cyclodextrin, an olefinic alcohol, a polyvinyl alcohol, an olefinic pyrrolidones, a polyvinyl pyrrolidone, a polysaccharide, an acrylic, methacrylic acid or a homopolymer and copolymer of acrylamide, etc.. In particular, it is preferable to use a water-soluble polymer compound having excellent crystallinity. Specifically, when a polyvinyl alcohol is used as a main component, it is possible to obtain the most excellent results for basic characteristics such as oxygen barrier properties and development removability.

For embodiments of the present invention, the lasers used to expose the lithographic printing plate precursors of the present invention may be carbon arc lamps, high pressure mercury lamps, xenon lamps, metal halide lamps, fluorescent lamps, tungsten lamps, halogen lamps, helium cadmium laser, argon ion laser, FD-YAG laser, helium-neon laser, semiconductor laser (350nm-450nm) perform image exposure on the photosensitive layer. The high-performance laser or laser diode used in commercially available image digital platemakers has an emission wavelength of 405nm, and the imaging device can be configured as a flat plate recorder or a drum recorder in which the imageable element is mounted to the inner or outer cylindrical surface of the drum. Suitable exposure equipment is, for example: CTCP/UV imaging machines of CRON (Korei) and AMSKY (Polyte), Xeikon UV equipment of BasysPrint, Xpose UV equipment of Liischer, and Nautilius equipment of ECRM. Depending on the sensitivity of the radiation-sensitive layer, the imaging is generally performed with an energy of 30 mJ/cm² to 500 mJ/cm², preferably 50 mJ/cm² to 300 mJ/cm².

It can be selected to pre-heat or non-preheat the printing plate precursor according to actual requirements after the exposure and prior to development. In general, a printing plate subjected to pre-heating prior to development has more or less increasing print durability. The imaged lithographic printing plate, which is finally produced by the aforementioned development process, is mounted on a printing press, coated with a printing ink and a dampening solution for printing, wherein the fountain solution is not absorbed by unimaged areas (hydrophilic substrate surface uncovered by imaging and rinsing steps), and the ink is absorbed by imaged (unremoved) areas. The ink is then transferred to a suitable receiving material (such as cloth, paper, metal, glass or plastic) to provide the desired impression of the image thereon. If necessary, an intermediate "transfer roller" can be used to transfer ink from the imaging member to the receiving material.

The platemaking of a lithographic printing plate provided by the present invention will be described in detail below with reference to specific embodiments. Most compounds of the components in the examples are available from Aldrich Chemical Company (Milwaukee, WI) unless otherwise specifically stated below.

Some of the specific components and materials used in the following examples are as follows:
Binder A is a polymer dispersion having 90% by weight of styrene and 10% by weight polyethylene glycol methyl ether methacrylate in propanol/water (80/20 volume ratio) with a solids content of 23.7%.
Binder B is a solution of a polymer containing 80% by weight of methyl methacrylate and 20% by weight of methacrylic acid in 2-butanone with a concentration of 33%.
Binder C is a polymer dispersion having 92% by weight of methyl methacrylate and 8% by weight of polyethylene glycol methyl ether methacrylate in propanol/water (80/20 volume ratio), with a solid content of 24.0%.
Binder D is a polymer dispersion having 20% by weight of styrene, 70% by weight of cyanoethyl acrylate and 10% by weight of polyethylene glycol methyl ether methacrylate in propanol/water (80/20 volume ratio), with a solid content of 23.8%.
Binder E is a polymer solution having 90% by weight of allyl methacrylate by weight and 10% by weight of polyethylene glycol methyl ether methacrylate in 2-butanone, with a solid content of 10%.
Free radical polymerizable compound A: reaction product of 1,6-hexadiisocyanate with hydroxyethyl acrylate and pentaerythritol triacrylate (polymer solution in 2-butanone, solid content of 80%)
Sartomer 355 is a multifunctional acrylic monomer, which is available from Sartomer Co., Inc.
PI-18 is 2-(4-methoxy-1-naphthyl)-4,6-bis(trichloromethyl)-1,3,5-triazine, which is commercially available from DKSH Group (Zurich, Switzerland).
Irgacure ^{®} 250 is (4-methoxyphenyl)[4-(2-methylpropyl)phenyl]iodonium hexafluorophosphate, which is commercially available from Ciba Specialty Chemicals (Tarrytown, NY).
PI-0591 is an iodonium salt initiator, which is commercially available from Tokyo Chemical Industry Co., Ltd., Japan.
BYK-341 silicone surface additive is available from Becker, Germany.
TMSPMA represents 3-(methacryloyloxy)-propyltrimethoxysilane.
Developing solution A is a solution prepared as follows: dissolving successively 13g sodium carbonate and 7g sodium bicarbonate; 50g sodium dodecyl benzene sulfonate; 25g arabic gum; 50g glycol monophenyl ether; 20g p-toluenesulfonic acid; and 0.1g SILFOAM^{®}SE 47 defoamer in 750g deionized water under stirring; then adding deionized water to 1000 g. The pH of developing solution A is 8.9.
Developing solution B is a solution prepared as follows: dissolving successively 25g sodium bicarbonate and 5g sodium carbonate; 50g sodium n-butyl naphthalene sulfonate; 3.0g ethylene diamine tetraacetic acid; 0.1g SILFOAM^{®}SE 47 defoamer in 750g deionized water with stirring; then adding deionized water to 1000 g. The pH of developing solution B is 7.4.

### EXAMPLE 1

The imageable composition described in this Example comprises the following weight percentages:
3.53 g of binder A,
3.74 g of free radical polymerizable compound A,
0.78g of Sartomer 355,
0.42g of 2-(4-methoxyphenyl)-4, 6-di (trichloromethyl) -2-triazine,
0.23g of aniline N, N-diacetic acid,
0.07g of polyacrylic acid,
0.005g of Victoria Pure Blue BO,
0.005 g of TMSPMA, and
0.02 g of BYK-307

The above-mentioned components were dissolved in a mixed solvent of 20.2g of 1-methoxy-2-propanol, 9.5g of water and 16.5g of 2-butanone, and the solution was coated on the aluminum plate base obtained by electrochemical roughening and anodizing by rotating coating method, and then dried in a 110°C oven for 2min. A lithographic plate precursor with a weight of 1.2 g/m³ of the coating was prepared.

The resulting precursor of the lithographic printing plate can be processed using a 405nm laser on a CRON's UVP-820G+CTcP platemaking machine, with a drum rotation speed of 500rpm and a laser power of 45mW. After pattern scanning and exposure, it can be washed with the above-mentioned develop solution A for 35 seconds using the MASTER VIEW developing machine at a temperature of 25°C to obtain a good image. Alternatively, the lithographic precursors can be directly exposed through the UV printing machine and then installed directly on the press to print more than 500 prints with good quality.

### EXAMPLE 2

The imageable composition described in this Example comprises the following weight percentages:
2.22 g of binder A,
2.44 g of free radical polymerizable compound A,
0.51g of Sartomer 355,
0.29g of diphenyliodonium chloride,
0.23g of aniline N, N-diacetic acid,
0.06g of coumarone 93,
0.08g of polyacrylic acid,
0.005g of Victoria Pure Blue BO,
0.005 g of TMSPMA, and
0.02 g of BYK-307

The above-mentioned components were dissolved in a mixed solvent of 20.2g of 1-methoxy-2-propanol, 9.5g of water and 16.5g of 2-butanone, and the solution was coated on the aluminum plate base obtained by electrochemical roughening and anodizing by rotating coating method, and then dried in a 110°C oven for 2min. A lithographic plate precursor with a weight of 1.2 g/m³ of the coating was prepared.

The resulting precursor of the lithographic printing plate can be processed using a 405nm laser on a CRON's UVP-820G+CTcP platemaking machine, with a drum rotation speed of 500rpm and a laser power of 45mW. After pattern scanning and exposure, it can be washed with the above-mentioned develop solution A for 35 seconds using the MASTER VIEW developing machine at a temperature of 25°C to obtain a good image. Alternatively, the lithographic precursors can be directly exposed through the UV printing machine and then installed directly on the press to print more than 500 prints with good quality.

### EXAMPLE 3

The imageable composition described in this Example comprises the following weight percentages:
0.6 g of binder A,
1.98 g of binder E,
3.25 g of free radical polymerizable compound A,
0.32g of Irgacure 250,
0.28 g of tert-butylammonium butyl triphenyl borate,
0.18g of mercaptotriazole,
0.07 g of polyethylene glycol,
0.005g of Victoria Pure Blue BO,
0.005 g of TMSPMA, and
0.02 g of BYK-307

The above-mentioned components were dissolved in a mixed solvent of 20.2g of 1-methoxy-2-propanol, 9.5g of water and 16.5g of 2-butanone, and the solution was coated on the aluminum plate base obtained by electrochemical roughening and anodizing by rotating coating method, and then dried in a 110°C oven for 2min. The weight of the first coating obtained was 1.2 g/m². Then, a solution of arabic gum (3.0g) and water (94.0g) was used to cover the top of the first coating, and again dried in the oven at 110°C for 2min, that is, a lithographic plate precursor with a total weight of 2.2 g/m³ of the double coating was prepared.

The resulting precursor of the lithographic printing plate can be processed using a 405nm laser on a CRON's UVP-820G+CTcP platemaking machine, with a drum rotation speed of 500rpm and a laser power of 45mW. After pattern scanning and exposure, it can be washed with the above-mentioned develop solution B for 35 seconds using the MASTER VIEW developing machine at a temperature of 25°C to obtain a good image. Alternatively, the lithographic precursors can be directly exposed through the UV printing machine and then installed directly on the press to print more than 500 prints with good quality.

### EXAMPLE 4

The imageable composition described in this Example comprises the following weight percentages:
2.60 g of binder C,
0.78 g of binder B,
3.25 g of free radical polymerizable compound A,
0.40g of PI-0591,
0.18g of PI-18,
0.08 g of polyethylene glycol,
0.005g of Victoria Pure Blue BO,
0.005 g of TMSPMA, and
0.02 g of BYK-307

The above-mentioned components were dissolved in a mixed solvent of 20.2g of 1-methoxy-2-propanol, 9.5g of water and 16.5g of 2-butanone, and the solution was coated on the aluminum plate base obtained by electrochemical roughening and anodizing by rotating coating method, and then dried in a 110°C oven for 2min. A lithographic plate precursor with a weight of 1.2 g/m³ of the coating was prepared.

The resulting precursor of the lithographic printing plate can be processed using a 405nm laser on a CRON's UVP-820G+CTcP platemaking machine, with a drum rotation speed of 500rpm and a laser power of 45mW. After pattern scanning and exposure, it can be washed with the above-mentioned develop solution B for 35 seconds using the MASTER VIEW developing machine at a temperature of 25°C to obtain a good image. Alternatively, the lithographic precursors can be directly exposed through the UV printing machine and then installed directly on the press to print more than 500 prints with good quality.

### EXAMPLE 5

The imageable composition described in this Example comprises the following weight percentages:
2.22 g of binder D,
2.44 g of free radical polymerizable compound A,
0.51g of Sartomer 355,
0.29 g of bis (4-tert butylphenyl) iodonium hexafluorophosphate,
0.05g of phenyl bis (2,4,6-trimethylbenzoyl) phosphine oxide,
0.08 g of arabic gum,
0.005g of Victoria Pure Blue BO,
0.005 g of TMSPMA, and
0.02 g of BYK-307

The above-mentioned components were dissolved in a mixed solvent of 20.2g of 1-methoxy-2-propanol, 9.5g of water and 16.5g of 2-butanone, and the solution was coated on the aluminum plate base obtained by electrochemical roughening and anodizing by rotating coating method, and then dried in a 110°C oven for 2min. The weight of the first coating obtained was 1.2 g/m². Then, a solution of polyvinyl alcohol (3.0g) and water (94.0g) was used to cover the top of the first coating, and again dried in the oven at 110°C for 2min, that is, a lithographic plate precursor with a total weight of 2.1 g/m³ of the double coating was prepared.

The resulting precursor of the lithographic printing plate can be processed using a 405nm laser on a CRON's UVP-820G+CTcP platemaking machine, with a drum rotation speed of 500rpm and a laser power of 45mW. After pattern scanning and exposure, it can be washed with the above-mentioned develop solution A for 35 seconds using the MASTER VIEW developing machine at a temperature of 25°C to obtain a good image. Alternatively, the lithographic precursors can be directly exposed through the UV printing machine and then installed directly on the press to print more than 500 prints with good quality.

Obviously, the above examples are merely examples made for clear description, rather limiting the implementations. For those of ordinary skill in the art, other different forms of variations or modifications can also be made on the basis of the above-mentioned description. All embodiments are not necessary to be and cannot be exhaustively listed herein. In addition, obvious variations or modifications derived therefrom all fall within the scope of protection of the present invention.

## Claims

1. An imageable composition for a photosensitive negative-working lithographic printing plate, wherein the imageable composition comprises the following components in parts by mass:
25 to 65 parts of a free radical polymerizable compound,
0.5 to 25 parts of a photoinitiator,
10 to 60 parts of a binder, and
1 to 20 parts of a development accelerator;
wherein the free radical polymerizable compound is a polymerizable monomer and/or oligomer containing at least one ethylenically unsaturated bond;
the photoinitiator has one or more absorption peaks or absorption shoulder bands in the UV-violet range;
the binder is a polymer with a main chain containing carbons;
the development accelerator is a low molecular weight hydrophilic organic compound or a high molecular weight hydrophilic polymer.

2. The imageable composition of claim 1, wherein the photoinitiator is sensitive to radiation in a wavelength ranging from 350nm to 450nm.

3. The imageable composition of claim 1, wherein the polymerizable monomer and/or oligomer is one or more of acrylate, methacrylate, urethane acrylate, urethane methacrylate, cyclic oxide acrylates or cyclic oxide methacrylates, polyol acrylates, polyol methacrylates, urethane acrylates, urethane methacrylates, polyether acrylates and polyether methacrylates.

4. The imageable composition of claim 1, wherein the photoinitiator is one or more of onium salt, trihalomethyl compound, carbonyl compound, azide compound, coumarin, ketocoumarin, anthraquinone , organoboron compound, oxime ester and phosphine oxide.

5. The imageable composition of claim 1, wherein the polymer with a main chain containing carbons is a polymer derived from at least one of acrylic acid, methacrylic acid, acrylate, methacrylate, acrylamide, methacrylamide, styrene and derivatives thereof, acrylonitrile, methacrylonitrile, N-substituted cyclic imides, and maleic anhydride constituting repeating units.

6. The imageable composition of claim 1, wherein the polymer with a main chain containing carbon has an average molecular weight ranging from 5,000 to 100,000.

7. The imageable composition of claim 1, wherein the low molecular weight hydrophilic organic compound used as the development accelerator is polyhydric alcohol and ether or ester derivatives thereof, organic amine and salts thereof, organic sulfonic acids and salts thereof; the high molecular weight hydrophilic polymers used as development accelerator is polyethylene glycol, gum arabic, starch, cellulose, dextrin, polysaccharides, and homopolymers or copolymers containing carboxyl, sulfonic acid, phosphonic acid, amide group, and vinyl pyrrolidone monomers.

8. A platemaking method for a photosensitive negative-working lithographic printing plate, wherein the method comprises the following steps:
(1) coating on a substrate, which has a hydrophilic surface or a hydrophilic layer, with an imageable composition of any one of claims 1-6 to obtain a photosensitive negative-working lithographic printing plate precursor;
(2) patternedly exposing the lithographic printing plate precursor to form an exposed region and an unexposed region;
(3) removing the unexposed region from the exposed printing plate precursor by means of a development process, so as to obtain a required lithographic printing plate, the development process is any one of (i) on-press development: using a dampening solution and/or lithography ink to perform development on a printing machine; and (ii) off-press development: using a developing solution to develop in a plate processor outside the printing machine.

9. The platemaking method of claim 8, wherein the developing solution for off-press development comprises a carbonate and/or a bicarbonate, and the carbonate and/or the bicarbonate in the developing solution has a mass fraction ranging from 1% to 20%, and the pH value of the developing solution is in a range from 6 to 11.

10. The platemaking method of claim 9, wherien the carbonate in the developing solution is an alkali metal carbonate; and the bicarbonate in the developing solution is an alkali metal bicarbonate.
